# FASCICULE DE BREVET EUROPEEN

(11) **EP 3 080 625 B1**
(45) Date de publication et mention de la délivrance du brevet: **11.03.2020**
(21) Numéro de dépôt: 14820779.8
(22) Date de dépôt: 11.12.2014
(51) Int. Cl.: G01R 31/36

(54) **PROCEDE D'ESTIMATION DE L'ETAT DE SANTE D'UNE BATTERIE**
VERFAHREN ZUR SCHÄTZUNG DES GESUNDHEITSSTATUS EINER BATTERIE
METHOD FOR ESTIMATING THE STATE OF HEALTH OF A BATTERY

(30) Priorité: 12.12.2013 FR 1362456
(43) Date de publication de la demande: 19.10.2016
(73) Titulaire: Commissariat à l'Énergie Atomique et aux Énergies Alternatives, 75015 Paris (FR)
(72) Inventeur: GROLLEAU, Sébastien, 78990 Elancourt (FR); DELAILLE, Arnaud, F-73000 Bassens (FR)
(74) Mandataire: Novaimo
(86) Numéro de dépôt international: PCT/EP2014/077397
(87) Numéro de publication internationale: WO 2015/086753

(56) Documents cités:
- EP-A1- 2 573 578
- WO-A1-2012/148070
- US-A1- 2012 169 288

## Description

L'invention concerne un procédé d'estimation de l'état de santé d'une batterie. Elle concerne aussi un système de gestion de batterie mettant en œuvre ce procédé d'estimation de l'état de santé d'une batterie.

La gestion des batteries de l'état de la technique fait appel à un indicateur représentatif du vieillissement d'une batterie, souvent appelé par sa dénomination anglo-saxonne de « State Of Health » pour état de santé, ou plus simplement SOH. Cet indicateur est usuellement exprimé en pourcentage de la capacité initiale à l'état neuf de la batterie, capacité mesurée dans cet état initial ou fournie par le fabricant de la batterie. Le SOH est couramment utilisé dans le diagnostic d'une batterie. Son évaluation est importante pour une bonne maîtrise du fonctionnement de la batterie, ainsi que pour gérer au mieux sa fin de vie.

Selon une première approche, la valeur réelle du SOH est mesurée en mettant en œuvre un test de capacité, consistant en une charge puis une décharge successive complètes de la batterie, dans des conditions choisies de température et de courant. Durant cette décharge, la quantité de charges restituée est mesurée, ce qui permet d'en déduire la capacité réelle de la batterie, et donc son SOH. L'avantage de cette méthode est d'obtenir la valeur réelle du SOH, puisqu'elle repose sur une mesure de la réalité. Toutefois, ses inconvénients sont qu'elle nécessite une durée importante, consomme de l'énergie, et nécessite une intervention sur la batterie qui est parfois incompatible avec son utilisation normale, c'est-à-dire de fourniture d'énergie pour la mise en œuvre d'une certaine application concrète : elle nécessite alors une pause de cette application, pour la mise en œuvre du test de la batterie. Pour cette dernière raison, cette première approche est considérée intrusive puisqu'elle nécessite généralement l'arrêt de l'utilisation normale de la batterie.

Pour pallier aux inconvénients de la mesure du SOH réel, d'autres approches moins intrusives existent, qui reposent sur son estimation. A titre d'exemple, une méthode usuelle pour estimer le SOH consiste à suivre l'évolution de la résistance de la batterie, ou par extension suivre un ou plusieurs paramètres d'impédance de la batterie. L'usure d'une batterie s'accompagne en effet généralement d'une évolution de ces paramètres. L'inconvénient de cette méthode est de ne pas mesurer directement la perte de capacité de la batterie, mais de l'estimer à partir de l'évolution d'un paramètre différent. Or, l'évolution des pertes de capacité et des augmentations de résistance, ou d'impédances, ne suivent pas des lois généralisables pour toutes les batteries, ni pour toutes les conditions de vieillissement des batteries. Ainsi, il existe des situations pratiques pour lesquelles l'augmentation de la résistance d'une batterie est parfois négligeable alors que la batterie subit une perte de capacité importante, et inversement. Cette méthode d'estimation reste donc insuffisamment fiable, et souvent complexe car elle nécessite des calculs complémentaires reposant par exemple sur un apprentissage préalable pour tenter de pallier à ses défaillances.

Le document WO2012/148070 consiste en un procédé d'estimation de l'état de sante (SOH) d'une batterie, à partir d'une première phase de calibration, qui consiste à choisir une plage d'évolution stable de la tension aux bornes d'une batterie en fonction du temps pendant sa charge.

Le document US20120169288 décrit un système de gestion d'une batterie qui repose sur la détection d'un ou deux pics de variation de la charge de la batterie en fonction de sa tension.

Le document EP2573578 décrit un procédé de diagnostic d'une batterie reposant sur le calcul de sa charge durant sa charge/décharge.

Ainsi, un objet général de l'invention est de proposer une solution d'estimation du SOH d'une batterie qui ne comprend pas tout ou partie des inconvénients de l'état de la technique.

Plus précisément, un objet de l'invention est de proposer une solution d'estimation du SOH d'une batterie, fiable, rapide, non intrusive.

A cet effet, l'invention repose sur un procédé d'estimation de l'état de santé (SOH) d'une batterie, caractérisé en ce qu'il comprend les phases suivantes :
- Première phase de calibration d'une ou plusieurs batteries de la même famille de batteries, comprenant :
   ▪ une étape de mesure de l'évolution de la charge en fonction de la tension ou inversement, lors d'une charge ou d'une décharge d'une batterie, pour une ou plusieurs valeurs d'état de santé de la ou des batterie(s) dont au moins son état neuf, et
   ▪ une étape de détection d'un maximum de la dérivée de la charge par la tension en fonction de la tension, ou inversement, et la détermination d'une plage favorable respectivement de tension ou de charge, la plage favorable correspondant à une charge ou décharge partielle d'une batterie qui inclut ce maximum, et
   ▪ une étape de détermination d'une loi entre une grandeur liée à une quantité de charge ou d'énergie fournie ou restituée par une batterie dans une phase de charge ou décharge de la batterie sur la plage favorable et l'état de santé de la batterie, notamment par interpolation linéaire à partir des mesures réalisées sur la plage favorable, et/ou la construction d'un abaque associant une valeur d'état de santé de la batterie à une grandeur liée à une quantité de charge ou d'énergie fournie ou restituée par la batterie, de sorte à déterminer des données de référence comprenant des informations sur une grandeur liée à une quantité de charge ou d'énergie fournie ou restituée par une batterie dans une phase de charge ou décharge de la batterie sur la plage favorable et l'état de santé de la batterie ;
- Seconde phase de mesure et d'estimation de l'état de santé de la batterie comprenant les deux étapes suivantes :
   o une étape de mesure d'au moins une grandeur liée à une quantité de charge ou d'énergie fournie ou restituée par la batterie dans une phase de charge ou de décharge partielle de la batterie sur la plage favorable ;
   o une étape d'estimation de l'état de santé de la batterie à partir du résultat de l'étape de mesure et des données de référence établies lors de la première phase de calibration.

La plage favorable peut être définie par une plage de tension strictement inclue dans la plage de variation totale de la tension aux bornes de la batterie dans une phase de charge ou de décharge totale, ou la plage favorable peut s'exprimer comme une plage d'état de charge SOC de la batterie strictement inclue dans la plage de variation totale de l'état de charge de la batterie dans une phase de charge ou de décharge totale.

L'étape d'estimation de l'état de santé de la batterie à partir du résultat de l'étape de mesure de la seconde phase de mesure et d'estimation peut comprendre une intégration dans le temps d'au moins une grandeur ou d'une combinaison de grandeurs liée(s) à une quantité de charge ou d'énergie fournie ou restituée par la batterie dans une phase de charge ou de décharge de la batterie, notamment calculée à partir de la tension, du courant et/ou de la température de la batterie sur la plage favorable.

L'étape de mesure de la seconde phase de mesure et d'estimation peut comprendre l'une des mesures suivantes :
- la charge ou la décharge est faite à courant constant I, l'étape de mesure comprend la mesure de la durée (t2-t1) de la charge ou décharge sur la plage favorable, pour en déduire une quantité de charge Q transmise ou restituée par la batterie par la formule Q = I ^{∗} (t2-t1) ; ou
- la charge ou la décharge est faite à courant variable I(t), l'étape de mesure comprend la mesure du courant I(t) et l'intégration du courant dans le temps entre les instants de départ t1 et de fin t2 de la plage favorable, pour en déduire une quantité de charge Q transmise ou restituée par la batterie par la formule Q = ∫ I dt ; ou
- l'étape de mesure comprend la mesure du courant I(t) et de la tension U(t) et l'intégration du produit du courant par la tension dans le temps entre les instants de départ t1 et de fin t2 de la plage favorable, pour en déduire une quantité d'énergie E transmise ou restituée par la batterie par la formule E = ∫ U. I dt .

L'étape de mesure de la seconde phase de mesure et d'estimation peut comprendre au moins une mesure d'une grandeur liée à une quantité de charge ou d'énergie fournie ou restituée par la batterie dans une phase de charge ou de décharge de la batterie sur une plage favorable dont les bornes sont :
- fixes quel que soit le vieillissement de la batterie, la variation de résistance interne de la batterie étant considérée comme négligeable ; ou
- fixes quel que soit le vieillissement de la batterie, les données de référence consultées pour l'estimation de l'état de santé à l'étape d'estimation, notamment sous forme d'abaque, permettant de prendre en compte une correction de la variation de résistance interne de la batterie avec son vieillissement ;
- variables avec le temps, leur variation étant calculée à partir d'une estimation ou d'un calcul de la résistance interne de la batterie, soit à partir d'une détection d'une variation d'un maximum de la dérivée de la charge par la tension en fonction de la tension, ou inversement, par rapport à ce maximum obtenu à l'état neuf de la batterie, soit par un calcul à partir d'impulsion de courant ou par impédancemétrie.

La phase de calibration peut être réalisée à partir d'au moins une batterie de la famille de batteries à l'état neuf, et à partir de la même batterie dans un état de vieillissement.

La phase de calibration peut mettre en œuvre une charge ou décharge à courant constant et/ou température constante et la phase de mesure et d'estimation de l'état de santé de la batterie peut mettre en œuvre une charge ou décharge partielle sur la plage favorable à courant constant et/ou température constante, le courant et la température étant choisis à sensiblement les mêmes valeurs que dans la phase de calibration.

La seconde phase de mesure et d'estimation peut comprendre tout ou partie des étapes préalables suivantes, en vue de déterminer son déclenchement :
- Commande de déclenchement suite à une demande d'un utilisateur par l'intermédiaire d'une interface homme machine d'un dispositif dans lequel la batterie est utilisée ou d'un dispositif de charge de la batterie ; et/ou
- Déclenchement automatique selon une fréquence prédéfinie ; et/ou
- Déclenchement automatique lorsque les conditions électriques de la batterie correspondent à la plage favorable ;
- déclenchement automatique lors d'une phase de charge d'une batterie ;

ET / OU peut comprendre les étapes préalables suivantes :
- Une étape de détection automatique de la situation électrique de la batterie pour détecter qu'elle se trouve dans la bonne configuration vis-à-vis de la plage favorable ; ou
- Une étape de modification de la configuration de la batterie pour la positionner au début de la plage favorable.

L'étape de mesure de la seconde phase de mesure et d'estimation peut comprendre la comparaison, notamment le rapport, de la grandeur liée à une quantité de charge ou d'énergie fournie ou restituée par une batterie calculée sur la plage favorable avec la même grandeur calculée de la même manière sur la plage favorable à l'état neuf de la batterie.

La plage favorable peut être décalée en fonction du vieillissement de la batterie pour corriger l'erreur induite par la modification de la résistance interne de la batterie.

L'invention porte aussi sur un support informatique lisible par une unité de gestion, caractérisé en ce qu'il comprend un programme informatique enregistré comprenant des moyens de codes de programme informatique de mise en œuvre du procédé d'estimation de l'état de santé d'une batterie tel que décrit précédemment.

L'invention porte aussi sur un dispositif comprenant au moins une batterie et une unité de gestion, caractérisé en ce que l'unité de gestion met en œuvre un procédé d'estimation de l'état de santé d'au moins une batterie tel que décrit précédemment.

Le dispositif peut être un véhicule automobile ou un objet portable comme un ordinateur, un téléphone, une tablette ou un agenda électronique.

Ces objets, caractéristiques et avantages de la présente invention seront exposés en détail dans la description suivante d'un mode de réalisation particulier fait à titre non-limitatif en relation avec les figures jointes parmi lesquelles :
La figure 1 représente plusieurs courbes d'évolution de la dérivée de la fonction représentant la charge transmise à une batterie de type Li-ion C/LFP (graphite / phosphate de fer) durant une phase de charge de la batterie en fonction de la tension aux bornes de la batterie pour respectivement plusieurs valeurs de SOH de la batterie.
La figure 2 représente plusieurs courbes d'évolution de la dérivée de la fonction représentant la charge transmise à une batterie de type Li-ion C/NMC (graphite / nickel manganèse cobalt) durant une phase de charge de la batterie en fonction de la tension aux bornes de la batterie pour respectivement plusieurs valeurs de SOH de la batterie.
La figure 3 représente une loi de variation entre des quantités de charge fournies à une batterie de type Li-ion C/LFP sur une plage favorable en fonction de son vieillissement.
La figure 4 représente une loi de variation entre des quantités de charge fournies à une batterie de type Li-ion C/NMC sur une plage favorable en fonction de son vieillissement.
La figure 5 représente schématiquement un organigramme d'un procédé d'estimation de l'état de santé d'une batterie selon un mode de réalisation de l'invention.
La figure 6 représente un tableau de données construit durant une phase de calibration de respectivement une batterie de type Li-ion C/LFP et d'une batterie de type Li-ion C/NMC.

Par la suite, le mode de réalisation de l'invention va être détaillé pour deux types particuliers de batteries, respectivement Li-ion C/LFP (graphite / phosphate de fer) et Li-ion C/NMC (graphite / nickel manganèse cobalt), de manière non limitative. Les modes de réalisation décrits peuvent aisément être adaptés et reproduits sur d'autres types de batteries, fonctionnant sur la base d'autres types de principe chimique.

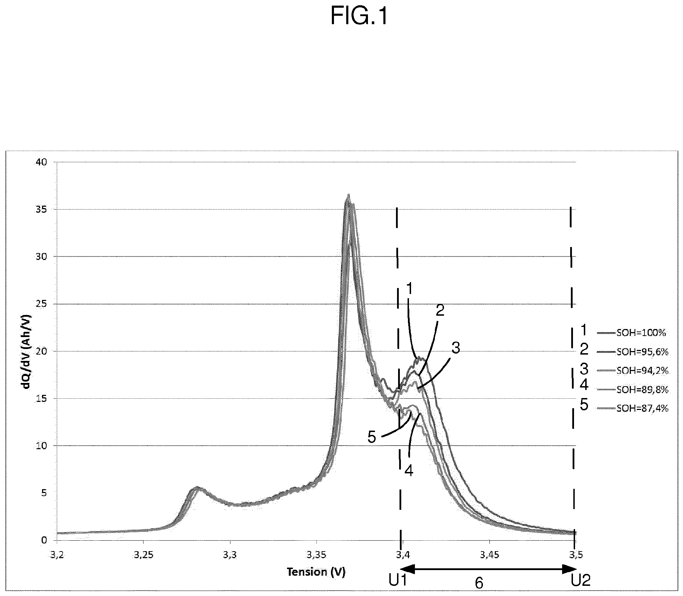

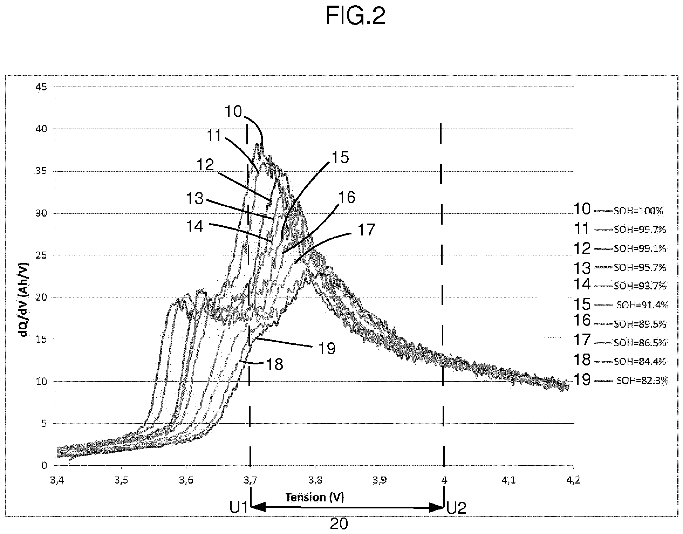

La figure 1 montre plus précisément cinq courbes 1 à 5, définies ci-dessus, obtenues pour respectivement des SOH respectifs de 100%, 95,6%, 94,2%, 89,8%, 87,4%. La figure 2 représente de manière similaire des courbes 10 à 19, définies ci-dessus, pour respectivement des SOH respectifs de 100%, 99,7%, 99,1%, 95,7%, 93,7%, 91,4%, 89,5%, 86,5%, 84,4%, 82,3%.

L'analyse de ces courbes montre qu'elles sont sensiblement superposées ou parallèles, et présentent certains pics, qui se reproduisent pour toutes les valeurs de SOH, pour sensiblement les mêmes valeurs de tension. Toutefois, ces pics présentent une hauteur qui varie sensiblement avec la valeur du SOH. Cette remarque nous permet de considérer que l'observation des phénomènes électriques d'une batterie dans une plage de tension entourant les pics est suffisante pour pouvoir en déduire une estimation précise du SOH. Autrement dit, il existe une plage de tension étroite autour de ces pics dont la considération peut permettre de déduire une estimation fiable du SOH. Cette plage de tension représente donc une plage favorable pour l'estimation du SOH. En remarque, sur la grande majorité des autres valeurs de tension, il n'y a pas de différence entre les courbes en fonction de l'état de santé de la batterie.

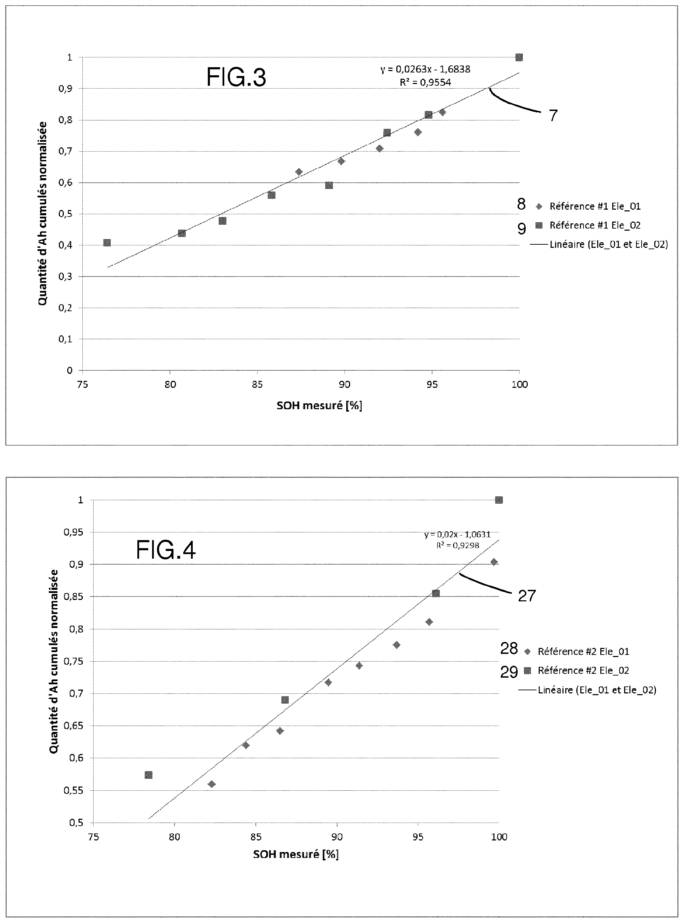

D'autre part, la surface délimitée par ces courbes et la plage favorable correspond par définition mathématique à la valeur de la quantité de charge transmise à la batterie durant sa charge entre les valeurs de tension sur la plage favorable : cette surface a donc par nature un lien avec l'état de santé SOH tel que couramment défini, sur la base de la capacité de la batterie, rappelé en préambule. On note en effet en pratique une corrélation assez simple entre la surface disposée sous chacune de ces courbes sur la plage favorable et la valeur de SOH associée à la courbe considérée, comme cela sera illustré par la suite en relation avec les figures 3 et 4.

D'autre part, les courbes illustrées ont été obtenues lors d'une phase de charge à courant et température constantes d'une batterie. Inversement, on constate le même phénomène lors d'une phase de décharge à courant et température constants. Ainsi, le mode de réalisation va être détaillé par la suite dans le cadre d'une charge de la batterie, mais pourrait toutefois inversement être implémenté en considérant une phase de décharge.

Enfin, la dérivée de la fonction de la charge en fonction de la tension a été observée sur les courbes des figures 1 et 2, mais on pourrait aussi en variante considérer la dérivée de la fonction de la tension en fonction de la charge. De plus, ces courbes ont été tracées en fonction de la tension, mais on pourrait en variante les tracer en fonction de l'état de charge de la batterie, grandeur usuellement dénommée SOC pour « State Of Charge ». Toutes ces grandeurs liées à une quantité de charge ou d'énergie fournie ou restituée par la batterie permettent en effet de caractériser le vieillissement d'une batterie, son état de santé.

Suite aux études précédentes, un mode de réalisation détaillé de l'invention va maintenant être explicité.

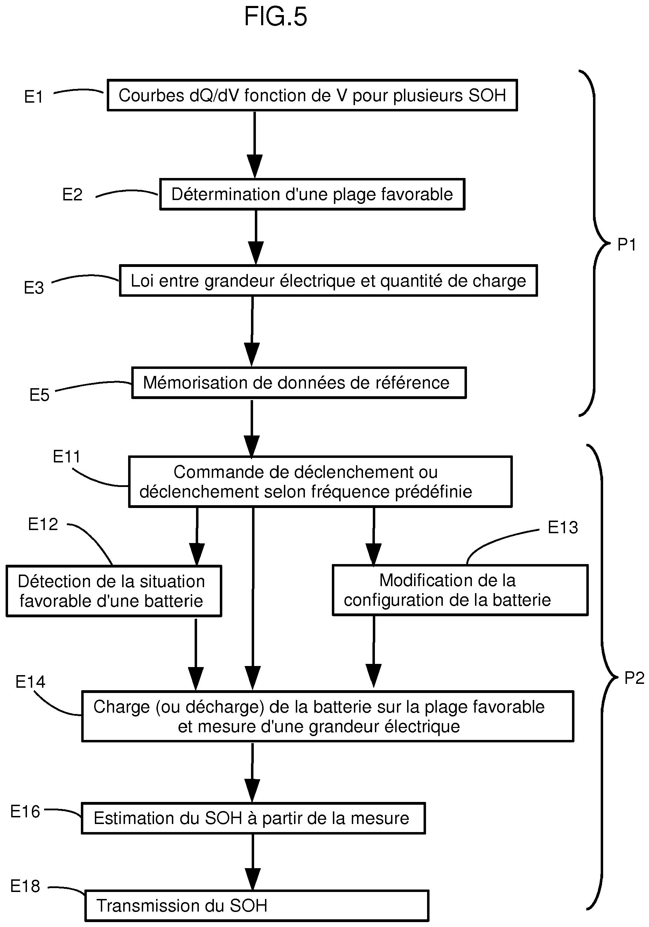

Ce mode de réalisation repose sur un procédé d'estimation de l'état de santé d'une batterie, représenté schématiquement par le diagramme de la figure 5, qui comprend les deux phases suivantes :
- Une première phase préalable de calibration P1 permettant d'identifier au moins une plage favorable et d'élaborer certaines données de référence liées à cette plage ;
- Une seconde phase de mesure P2 d'au moins une grandeur électrique, comme une charge et/ou une tension et/ou un courant, sur la plage favorable, pour estimer le SOH.

Selon le mode de réalisation, la phase de calibration P1 consiste donc à rechercher une plage favorable pour la batterie considérée, et à retenir des données de référence liées à cette plage favorable.

Par exemple, en reprenant les exemples d'une batterie Li-ion C/LFP (graphite / phosphate de fer) ou d'une batterie Li-ion C/NMC (graphite / nickel manganèse cobalt), une première étape E1 de la phase de calibration P1 consiste à tracer les courbes dQ/dV en fonction de la tension V des figures 1 ou 2, pour quelques valeurs différentes de SOH. En remarque, dans cette première phase de calibration, le SOH est calculé par une méthode connue et très précise, afin d'établir une calibration précise avec des valeurs réelles pour atteindre une grande performance lors des futures estimations.

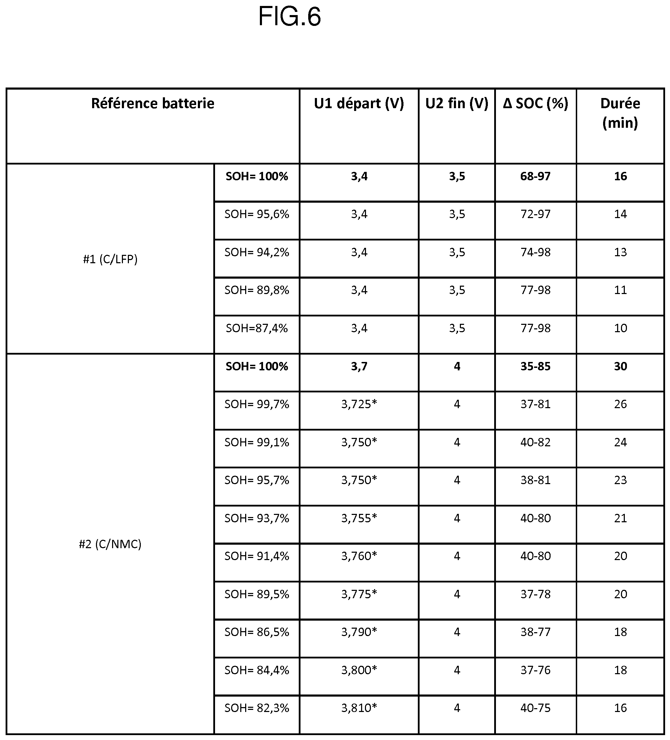

Une deuxième étape E2 consiste à déterminer une plage favorable et des données de référence associées, représentées par le tableau de la figure 6. En effet, ce tableau montre qu'on peut sélectionner les valeurs de tension autour du troisième pic dans l'exemple de la batterie de type Li-ion C/LFP, dans une plage favorable 6 mise en évidence sur la figure 1, définie par l'intervalle de tension [U1 ; U2] pour lequel on peut considérer U1 = 3,4 V et U2 = 3,5 V de manière constante et indépendante du SOH. Sur cet intervalle, les variations de l'état de charge SOC de la batterie ainsi que le temps de charge sont aussi mesurés, comme mentionné dans les deux dernières colonnes du tableau de la figure 6. Dans le cas de la batterie de type Li-ion C/NMC, la plage favorable 20 correspond par exemple à un intervalle [U1=3,7V ; U2 = 4V], et les mêmes données de référence sont mentionnées dans le tableau de la figure 6. En remarque, on note ici une variante de réalisation qui sera explicitée par la suite dans laquelle la plage favorable de tension est variable avec le SOH. En remarque, les valeurs de tension U1 et U2 sont choisies de sorte à former une plage étroite mais suffisante pour détecter le pic et réaliser les mesures nécessaires.

Ensuite, la phase de calibration selon ce mode de réalisation comprend une autre étape d'élaboration d'une loi E3 entre une grandeur électrique, comme la quantité de charges transmise à la batterie en charge sur la plage favorable, et la valeur réelle du SOH. Cette étape permet l'estimation future à partir des quelques valeurs discrètes mesurées expérimentalement à toutes autres valeurs, en définissant une relation continue entre une certaine grandeur électrique et les valeurs de SOH. Cette approche est possible parce que les grandeurs électriques considérées sont liées au SOH (tel que défini au préambule), sont des grandeurs liées à une quantité de charge ou d'énergie fournie ou restituée par la batterie, comme notamment la quantité de charges et/ou la tension et/ou le courant.

La figure 3 représente ainsi une droite 7 représentant la variation de la quantité de charges transmise à la batterie sur la plage favorable en fonction du SOH réel. Cette droite est obtenue par une interpolation linéaire de quelques points 8, 9 obtenus respectivement pour deux batteries de type Li-ion C/LFP positionnées dans différents états de vieillissement volontairement obtenus par des scénarios de vieillissement différents. De même, une droite 27 est construite à partir de quelques points 28, 29 obtenus respectivement pour deux batteries de type Li-ion C/NMC positionnées dans différents états de vieillissement volontairement obtenus par des scénarios de vieillissement différents.

En variante, un abaque peut être construit, permettant d'associer une valeur de SOH à chaque valeur de quantité de charges.

Cette phase de calibration comprend une dernière étape E5 de mémorisation des données de référence dans une mémoire électronique. Ces données de référence comprennent ici principalement les données du tableau de la figure 6 ainsi que les lois associées aux courbes 7, 27 définies ci-dessus. Naturellement, les valeurs de courant et température de référence pour lesquelles les charges de batterie sont réalisées sont aussi mémorisées comme données de référence, car le procédé sera mis en œuvre en utilisant toujours les mêmes conditions de charge, pour lesquelles les données de référence sont les plus pertinentes.

Naturellement, cette phase de calibration peut être réalisée une seule fois (sur une seule batterie) pour une certaine famille de batteries, voire plusieurs fois pour établir une moyenne qu'on espère plus précise, les résultats s'appliquant alors par la suite à toutes les batteries de la famille fonctionnant selon cette même technologie dans des phases distinctes lors de leur utilisation dans un système.

De plus, selon une variante simplifiée, le diagnostic pourrait se contenter du tracé d'une courbe à l'état neuf de la batterie, c'est-à-dire pour un SOH de 100%, en considérant que la découverte d'un pic suffit pour définir une ou plusieurs plages potentiellement favorables. Cette connaissance pourrait être complétée par au moins un pic complémentaire pour un vieillissement important. Par la suite, si on souhaite une grande précision, il est possible d'augmenter le nombre de valeurs de SOH réels considérées à l'étape E1 de la calibration et/ou de considérer plusieurs plages favorables : en pratique, le choix d'une seule plage favorable apparaît suffisant et choisi de préférence pour une raison évidente de simplicité.

Selon le mode de réalisation, lorsque la phase de calibration a été établie, une fois pour toute, le procédé peut se servir des résultats de calibration qui en résultent pour estimer le SOH de toute batterie du même type, durant toute la durée de vie de la batterie. Si nécessaire, la phase de calibration peut être recommencée, mais elle n'a pas vocation à être répétée.

Le procédé met ensuite en œuvre la seconde phase de mesure et d'estimation P2 du SOH, qui consiste à réaliser une charge de la batterie dans les conditions de température et/ou de courant de référence, puis à mesurer au moins une grandeur électrique liée à une quantité de charges ou d'énergie fournie ou restituée par la batterie durant cette phase de charge, sur la seule plage favorable, déterminée par la calibration. L'avantage de ce procédé, qui va apparaître évident par la suite de la description, est naturellement de ne nécessiter qu'une durée très réduite de charge de la batterie, puisque la seconde phase P2 est réduite à une plage favorable étroite, c'est-à-dire une charge partielle réduite de la batterie, pour obtenir une estimation précise du SOH de la batterie. Avantageusement, la plage favorable représente moins de 20% d'une charge ou décharge complète de la batterie, voire moins de 10%.

Selon le mode de réalisation, cette seconde phase P2 du procédé comprend les étapes suivantes :
- Une étape de mesure E14 d'au moins une grandeur électrique durant une charge de la batterie sur la plage favorable ;
- Une étape de calcul E16 d'une estimation du SOH à partir de la mesure précédente.

Cette seconde phase P2 comprend les étapes préalables suivantes, en vue de déclencher la seconde phase P2, selon ce mode de réalisation :
- Une étape de détection E12 automatique de la situation électrique de la batterie pour détecter qu'elle se trouve dans la bonne configuration vis-à-vis de la plage favorable ; ou en variante
- Une étape de modification E13 de la configuration de la batterie pour la positionner au début de la plage favorable.

Une autre étape préalable de déclenchement E11 de la seconde phase P2 peut reposer sur l'une des étapes suivantes :
- E11a : Commande de déclenchement suite à une demande d'un utilisateur par l'intermédiaire d'une interface homme machine du dispositif dans lequel la batterie est utilisée ou d'un dispositif de charge de la batterie ;
- E11b : Déclenchement automatique selon une fréquence prédéfinie ;
- E11c: Déclenchement automatique lorsque les conditions électriques de la batterie correspondent à la plage favorable ;
- E11d : déclenchement automatique lors d'une phase de charge d'une batterie (cette phase de charge étant déclenchée de manière indépendante, par exemple parce que la batterie est fortement déchargée).

Les étapes E11 et E12 ou E13 peuvent éventuellement être cumulées.

L'étape de mesure E14 repose ensuite sur une période de charge de la batterie, durant laquelle la tension est mesurée, pour déclencher la mesure de la charge entre les deux valeurs de tension U1, U2 prédéfinies en phase de calibration et correspondant à la plage favorable. Cette étape est réalisée dans les mêmes conditions que celles de la phase de calibration, notamment de courant et température.

Ainsi, en reprenant l'exemple de la batterie de type Li-ion C/LFP, la plage favorable 6 a été déterminée en phase de calibration sur l'intervalle de tension [U1 ; U2] = [3,4 V ; 3,5 V]. Comme la charge de la batterie est réalisée à courant I constant selon la valeur de référence selon cet exemple, la charge Q transmise à la batterie, qui est calculée comme l'intégration temporelle du courant (∫ I dt) entre les deux instants t1 et t2 pour lesquels la tension aux bornes de la batterie prend les valeurs U1 et U2, s'exprime simplement par Q = I (t2 - t1). Ainsi, la mesure de la charge transmise à la batterie se réduit à la mesure du temps de charge sur la plage favorable. C'est pourquoi ces seules valeurs de durées de charges ont été mentionnées précédemment dans le tableau de la figure 6.

Ensuite, lorsque la durée de la charge de la batterie sur la plage favorable est obtenue, on en déduit facilement la quantité de charges Q transmise à la batterie, par la relation Q = I (t2 - t1), mentionnée ci-dessus. La courbe 7, ou en variante un abaque ou toute loi établie en phase de calibration, permet ensuite de déduire de cette quantité de charges la valeur estimée du SOH, dans l'étape E16 d'estimation du SOH.

En variante, si le courant I de charge est variable, la charge Q transmise à la batterie est calculée par l'intégration temporelle du courant (∫ I dt) entre les deux instants t1 et t2 pour lesquels la tension aux bornes de la batterie prend les valeurs U1 et U2.

Naturellement, le procédé peut comprendre une dernière étape E18 de transmission de cette estimation à un opérateur, par l'intermédiaire d'une interface homme machine d'un certain dispositif.

Dans le second exemple d'une batterie de type Li-ion C/NMC, la plage favorable 20 est choisie sur l'intervalle de tension [U1 ; U2] = [3,7 V ; 4 V]. Toutefois, on note sur la figure 2 une déviation des pics des différentes courbes 10 à 19 avec le vieillissement de la batterie, alors que ces pics restaient sensiblement superposés sur la figure 1 liée au premier exemple étudié précédemment. Cette déviation s'explique par la modification de la résistance interne de la batterie avec son vieillissement, phénomène déjà souligné précédemment.

Si on dénomme V la tension aux bornes d'une batterie générant (ou recevant) un courant I, alors on peut modéliser la batterie par la relation V = OCV ± R I, où R est la résistance interne de la batterie et OCV sa tension sous courant nul (dit Open Circuit Voltage), le signe + correspondant au cas de la charge et le signe - au cas de la décharge. A l'état neuf de la batterie, sa tension peut s'écrire Vi = OCVi ± Ri I. La tension Vmi du maximum de la plage favorable 20 est caractérisée par une tension Vmi = OCVmi ± Ri I. Dans un état de vieillissement, la batterie présente une résistance interne Rv différente de la résistance initiale. Le maximum de la plage favorable 20 est alors caractérisé par la tension Vmv définie par Vmv = OCVmv ± Rv I. Le décalage observé entre Vmv et Vmi est donc égal à (Rv-Ri) I, et traduit donc bien l'augmentation de la résistance interne de la batterie.

Pour tenir compte de ce phénomène, qui entraîne une imprécision dans la mise en œuvre du procédé explicité ci-dessus, une première solution consiste à modifier les bornes U1, U2 en fonction du vieillissement de la batterie pour corriger la déviation naturelle du fait de la modification de sa résistance interne. Cette variation revient à repositionner la plage favorable, en déviant les deux bornes U1 et U2, de sorte à conserver toujours le même positionnement du maximum (pic) au sein de cette plage.

Pour réaliser cette correction, la seconde phase comprend une étape préalable E10 de mesure ou d'estimation de la résistance interne de la batterie. Cette étape peut se faire de manière connue, par exemple à partir d'impulsion de courant ou par impédancemétrie.

En variante, la courbe considérée à l'étape E1 de la phase de calibration peut être reconstruite ici, ce qui permet d'identifier le maximum recherché, de déterminer sa déviation par rapport au maximum associé à l'état neuf de la batterie, puis d'en déduire la correction en décalant les bornes de la plage favorable.

Le tableau de la figure 6 illustre cette variante de réalisation avec corrections.

Le mode de réalisation précédent est particulièrement avantageux puisqu'il permet de limiter la recherche fastidieuse des maximums lors de l'estimation de l'état de santé d'une batterie dans son utilisation dans un système, sans tracer par exemple les courbes mentionnées pour déterminer une plage favorable pendant la phase de calibration. Ensuite, l'estimation de l'état de santé de la batterie se fait par une mesure très simple et sur une plage réduite, durant une faible durée d'une phase de charge ou de décharge. Il n'y a donc notamment pas besoin de redessiner la courbe considérée à l'étape E1 de la phase de calibration P1, ni de rechercher le ou les pics mentionnés. En variante toutefois, cette courbe pourrait être retracée sur la plage favorable prédéterminée, donc sur une durée réduite : L'avantage de cette approche serait de permettre le calcul exact de l'état de santé de la batterie en calculant simplement la surface se trouvant sous la courbe sur la plage favorable et en faisant son rapport avec la surface correspondante à l'état neuf de la batterie. Cet avantage simplifierait la phase de calibration durant laquelle il ne serait plus nécessaire de mettre en œuvre l'étape E3 ni de calculer plusieurs courbes à l'étape E1, seule la courbe à l'état neuf (SOH = 100%) serait suffisant.

Les exemples précédents ont été obtenus sur la base d'une hypothèse de fonctionnement à température constante. Dans cette approche, la première phase de calibration est réalisée dans des conditions de température constante contrôlée, et la seconde phase est obtenue en reproduisant sensiblement les mêmes conditions de température. En variante, le mode de réalisation précédent peut être modifié en considérant la température variable : une première approche consisterait à limiter la variation de la température dans une plage réduite autour de la température de calibration (par exemple entre 20 et 30 ° C si la température de calibration est de 25 °C), afin de négliger l'influence de la variation de température, et une seconde approche consisterait à considérer la température comme une variable d'entrée des calculs considérés précédemment, l'estimation de l'état de santé SOH devenant alors aussi dépendant de la température.

D'autre part, dans le mode de réalisation précédent, la plage favorable a été définie à partir de valeurs de tension, cette plage s'exprimant comme une plage de tension [U1 ; U2]. En variante, elle peut s'exprimer à partir de l'état de charge, dénommé usuellement SOC pour « State Of Charge », cette dernière valeur devant alors être estimée. L'approche préférée par la tension présente l'avantage de la simplicité.

Le procédé précédent a été décrit sur la base de l'approche la plus répandue pour définir l'état de santé d'une batterie, qui consiste à considérer la perte en capacité de stockage d'une quantité de charges. En variante, le même procédé peut être adapté pour l'estimation de l'état de santé d'une batterie selon une autre approche, par exemple en considérant sa perte en possibilité de restitution d'énergie avec le temps. Dans une telle approche, l'adaptation de ce procédé peut être obtenue en remplaçant les quantités de charges par des quantités d'énergie. Ainsi, les étapes E14 et E16 décrites précédemment comprendront la mesure du courant I et de la tension U aux bornes de la batterie pendant sa charge ou décharge sur la plage favorable, puis l'énergie E reçue ou transmise par la batterie respectivement en charge ou décharge est calculée par l'intégration temporelle du produit du courant par la tension (∫ U I dt) entre les deux instants t1 et t2 pour lesquels la tension aux bornes de la batterie prend les valeurs U1 et U2.

Finalement, le mode de réalisation de l'invention présente les avantages suivants :
- Les calculs mis en œuvre dans la seconde phase P2 sont simples, ce qui permet leur mise en œuvre sans nécessiter une puissance de calcul élevée, et donc compatible avec une implémentation au sein de tout dispositif, comme un objet portable éventuellement de petite taille ;
- L'approche est facilement généralisable à tout type de batteries, il suffit de reproduire la phase de calibration au moins une fois pour chaque type de batteries ;
- Le procédé montre en pratique qu'il permet d'atteindre une très grande précision ;
- Le procédé permet une mise en œuvre de durée très faible, ce qui le rend non intrusif, car il peut facilement être mis en œuvre de manière opportuniste, sans déranger le fonctionnement normal de la batterie.

L'invention porte aussi sur un dispositif équipé d'une batterie et comprenant une unité de gestion mettant en œuvre le procédé d'estimation de l'état de santé (SOH) de la batterie tel que décrit précédemment, par des composants matériel et/ou logiciel. Pour cela, l'unité de gestion comprend un calculateur, est associée à au moins une mémoire électronique stockant notamment les données numériques de la première phase de calibration, et un logiciel de calcul mettant en œuvre tout ou partie du procédé d'estimation de l'état de santé (SOH). L'invention porte d'ailleurs aussi sur un tel logiciel en tant que tel. Le dispositif comprend aussi une interface homme machine permettant d'informer un utilisateur de l'état de charge de la batterie, et d'interagir avec lui pour définir certains paramètres du procédé, par exemple les conditions de déclenchement de l'estimation. Enfin, le dispositif comprend au moins un capteur de mesure de tension et/ou de courant et/ou de température relié(s) par un moyen de communication à l'unité de gestion. En remarque, le dispositif de gestion de la batterie, qui met en œuvre le procédé d'estimation de son état de santé, peut être intégré à la batterie elle-même.

A titre d'exemple non limitatif, le procédé d'estimation peut ainsi être intégré au sein d'un véhicule automobile, notamment un véhicule électrique ou hybride. Il peut aussi être implémenté dans un chargeur de batteries ou plus spécifiquement dans une borne de recharge de véhicules. Il peut aussi être implémenté au sein de tout objet portable, comme un ordinateur portable, une tablette, un téléphone portable, un agenda électronique, etc.).

## Revendications

1. Procédé d'estimation de l'état de santé (SOH) d'une batterie, **caractérisé en ce qu'**il comprend les phases suivantes :
- Première phase de calibration (P1) d'une ou plusieurs batteries de la même famille de batteries, comprenant :
▪ une étape (E1) de mesure de l'évolution de la charge en fonction de la tension ou inversement, lors d'une charge ou d'une décharge d'une batterie, pour une ou plusieurs valeurs d'état de santé de la ou des batterie(s) dont au moins pour son état neuf, et
▪ une étape (E2) de détection d'un maximum de la dérivée de la charge par la tension en fonction de la tension, ou inversement, et la détermination d'une plage favorable respectivement de tension ou de charge, la plage favorable correspondant à une charge ou décharge partielle d'une batterie qui inclut ce maximum, et
▪ une étape (E3) de détermination d'une loi entre une grandeur liée à une quantité de charge ou d'énergie fournie ou restituée par une batterie dans une phase de charge ou décharge de la batterie sur la plage favorable et l'état de santé de la batterie, notamment par interpolation linéaire à partir des mesures réalisées sur la plage favorable, et/ou la construction d'un abaque associant une valeur d'état de santé de la batterie à une grandeur liée à une quantité de charge ou d'énergie fournie ou restituée par la batterie, de sorte à déterminer des données de référence comprenant des informations sur une grandeur liée à une quantité de charge ou d'énergie fournie ou restituée par une batterie dans une phase de charge ou décharge de la batterie sur la plage favorable et l'état de santé de la batterie ;
- Seconde phase de mesure et d'estimation (P2) de l'état de santé de la batterie comprenant les deux étapes suivantes :
• une étape de mesure (E14) d'au moins une grandeur liée à une quantité de charge ou d'énergie fournie ou restituée par la batterie dans une phase de charge ou de décharge partielle de la batterie sur la plage favorable ;
• une étape d'estimation (E16) de l'état de santé de la batterie à partir du résultat de l'étape de mesure (E14) et des données de référence établies lors de la première phase de calibration.

2. Procédé d'estimation de l'état de santé d'une batterie selon la revendication précédente, **caractérisé en ce que** la plage favorable est définie par une plage de tension strictement inclue dans la plage de variation totale de la tension aux bornes de la batterie dans une phase de charge ou de décharge totale, ou **en ce que** la plage favorable s'exprime comme une plage d'état de charge SOC de la batterie strictement inclue dans la plage de variation totale de l'état de charge de la batterie dans une phase de charge ou de décharge totale.

3. Procédé d'estimation de l'état de santé d'une batterie selon l'une des revendications précédentes, **caractérisé en ce que** l'étape d'estimation (E16) de l'état de santé de la batterie à partir du résultat de l'étape de mesure (E14) de la seconde phase de mesure et d'estimation (P2) comprend une intégration dans le temps d'au moins une grandeur ou d'une combinaison de grandeurs liée(s) à une quantité de charge ou d'énergie fournie ou restituée par la batterie dans une phase de charge ou de décharge de la batterie, notamment calculée à partir de la tension, du courant et/ou de la température de la batterie sur la plage favorable.

4. Procédé d'estimation de l'état de santé d'une batterie selon la revendication précédente, **caractérisé en ce que** l'étape de mesure (E14) de la seconde phase de mesure et d'estimation (P2) comprend l'une des mesures suivantes :
- la charge ou la décharge est faite à courant constant I, l'étape de mesure (E14) comprend la mesure de la durée (t2-t1) de la charge ou décharge sur la plage favorable, pour en déduire une quantité de charge Q transmise ou restituée par la batterie par la formule Q = I ^{∗} (t2-t1) ; ou
- la charge ou la décharge est faite à courant variable I(t), l'étape de mesure (E14) comprend la mesure du courant I(t) et l'intégration du courant dans le temps entre les instants de départ t1 et de fin t2 de la plage favorable, pour en déduire une quantité de charge Q transmise ou restituée par la batterie par la formule Q = ∫ I dt ; ou
- l'étape de mesure (E14) comprend la mesure du courant I(t) et de la tension U(t) et l'intégration du produit du courant par la tension dans le temps entre les instants de départ t1 et de fin t2 de la plage favorable, pour en déduire une quantité d'énergie E transmise ou restituée par la batterie par la formule E = ∫ U. I dt .

5. Procédé d'estimation de l'état de santé d'une batterie selon l'une des revendications précédentes, **caractérisé en ce que** l'étape de mesure (E14) de la seconde phase de mesure et d'estimation (P2) comprend au moins une mesure d'une grandeur liée à une quantité de charge ou d'énergie fournie ou restituée par la batterie dans une phase de charge ou de décharge de la batterie sur une plage favorable dont les bornes sont :
- fixes quel que soit le vieillissement de la batterie, la variation de résistance interne de la batterie étant considérée comme négligeable ; ou
- fixes quel que soit le vieillissement de la batterie, les données de référence consultées pour l'estimation de l'état de santé à l'étape d'estimation (16), notamment sous forme d'abaque, permettant de prendre en compte une correction de la variation de résistance interne de la batterie avec son vieillissement ;
- variables avec le temps, leur variation étant calculée à partir d'une estimation ou d'un calcul de la résistance interne de la batterie, soit à partir d'une détection d'une variation d'un maximum de la dérivée de la charge par la tension en fonction de la tension, ou inversement, par rapport à ce maximum obtenu à l'état neuf de la batterie, soit par un calcul à partir d'impulsion de courant ou par impédancemétrie.

6. Procédé d'estimation de l'état de santé d'une batterie selon l'une des revendications précédentes, **caractérisé en ce que** la phase de calibration (P1) est réalisée à partir d'au moins une batterie de la famille de batteries à l'état neuf, et à partir de la même batterie dans un état de vieillissement.

7. Procédé d'estimation de l'état de santé d'une batterie selon l'une des revendications précédentes, **caractérisé en ce que** la phase de calibration (P1) met en œuvre une charge ou décharge à courant constant et/ou température constante et **en ce que** la phase de mesure et d'estimation (P2) de l'état de santé de la batterie met en œuvre une charge ou décharge partielle sur la plage favorable à courant constant et/ou température constante, le courant et la température étant choisis à sensiblement les mêmes valeurs que dans la phase de calibration.

8. Procédé d'estimation de l'état de santé d'une batterie selon l'une des revendications précédentes, **caractérisé en ce que** la seconde phase de mesure et d'estimation (P2) comprend tout ou partie des étapes préalables suivantes, en vue de déterminer son déclenchement :
- (E11a) Commande de déclenchement suite à une demande d'un utilisateur par l'intermédiaire d'une interface homme machine d'un dispositif dans lequel la batterie est utilisée ou d'un dispositif de charge de la batterie ; et/ou
- (E11b) Déclenchement automatique selon une fréquence prédéfinie ; et/ou
- (E11c) Déclenchement automatique lorsque les conditions électriques de la batterie correspondent à la plage favorable ;
- (E11d) : déclenchement automatique lors d'une phase de charge d'une batterie ;
ET / OU **en ce qu'**elle comprend les étapes préalables suivantes :
- Une étape de détection (E12) automatique de la situation électrique de la batterie pour détecter qu'elle se trouve dans la bonne configuration vis-à-vis de la plage favorable ; ou
- Une étape de modification (E13) de la configuration de la batterie pour la positionner au début de la plage favorable.

9. Procédé d'estimation de l'état de santé d'une batterie selon la revendication précédente, **caractérisé en ce que** l'étape de mesure (E14) de la seconde phase de mesure et d'estimation (P2) comprend la comparaison, notamment le rapport, de la grandeur liée à une quantité de charge ou d'énergie fournie ou restituée par une batterie calculée sur la plage favorable avec la même grandeur calculée de la même manière sur la plage favorable à l'état neuf de la batterie.

10. Procédé d'estimation de l'état de santé d'une batterie selon l'une des revendications précédentes, **caractérisé en ce que** la plage favorable est décalée en fonction du vieillissement de la batterie pour corriger l'erreur induite par la modification de la résistance interne de la batterie.

11. Support informatique lisible par une unité de gestion, **caractérisé en ce qu'**il comprend un programme informatique enregistré comprenant des moyens de codes de programme informatique de mise en œuvre du procédé d'estimation de l'état de santé d'une batterie selon l'une des revendications précédentes.

12. Dispositif comprenant au moins une batterie et une unité de gestion, **caractérisé en ce que** l'unité de gestion met en œuvre un procédé d'estimation de l'état de santé d'au moins une batterie selon l'une des revendications 1 à 10.

13. Dispositif selon la revendication précédente, **caractérisé en ce qu'**il est un véhicule automobile ou un objet portable comme un ordinateur, un téléphone, une tablette ou un agenda électronique.

## Patentansprüche

1. Verfahren zur Schätzung des Gesundheitszustands (SOH) einer Batterie, **dadurch gekennzeichnet, dass** es die folgenden Phasen umfasst:
- erste Phase des Kalibrierens (P1) einer oder mehrerer Batterien derselben Batteriefamilie, umfassend:
• einen Schritt (E1) des Messens des Verlaufs der Ladung in Abhängigkeit von der Spannung oder umgekehrt bei einem Aufladen oder Entladen einer Batterie für einen oder mehrere Gesundheitszustandswerte der Batterie(n), darunter zumindest für ihren Neuzustand, und
• einen Schritt (E2) des Detektierens eines Maximums der Ableitung der Ladung durch die Spannung in Abhängigkeit von der Spannung oder umgekehrt und das Bestimmen eines jeweiligen günstigen Spannungs- oder Ladungsbereichs, wobei der günstige Bereich einer Teilaufladung oder Teilentladung einer Batterie entspricht, die dieses Maximum beinhaltet, und
• einen Schritt (E3) des Bestimmens einer Gesetzmäßigkeit zwischen einer Größe, die mit einer Ladungs- oder Energiemenge, die von einer Batterie in einer Auflade- oder Entladephase der Batterie über den günstigen Bereich aufgenommen oder abgegeben wird, und dem Gesundheitszustand der Batterie verknüpft ist, insbesondere durch lineare Interpolation anhand der über den günstigen Bereich ausgeführten Messungen und/oder das Erstellen eines Diagramms, in dem ein Gesundheitszustandswert einer Batterie einer Größe zugeordnet wird, die mit einer von der Batterie aufgenommenen oder abgegebenen Ladungs- oder Energiemenge verknüpft ist, so dass Referenzdaten bestimmt werden, die Informationen über eine Größe, die mit einer Ladungs- oder Energiemenge verknüpft ist, die von einer Batterie in einer Auflade- oder Entladephase über den günstigen Bereich aufgenommen oder abgegeben wird, und den Gesundheitszustand der Batterie umfassen;
- zweite Phase des Messens und Schätzens (P2) des Gesundheitszustands der Batterie, welche die beiden folgenden Schritte umfasst:
• einen Schritt des Messens (E14) mindestens einer Größe, die mit einer Ladungs- oder Energiemenge verknüpft ist, die von der Batterie in einer Teilauflade- oder Teilentladephase über den günstigen Bereich aufgenommen oder abgegeben wird;
• einen Schritt des Schätzens (E16) des Gesundheitszustands der Batterie anhand des Ergebnisses des Messschritts (E14) und der während der ersten Kalibrierungsphase ermittelten Referenzdaten.

2. Verfahren zur Schätzung des Gesundheitszustands einer Batterie nach dem vorhergehenden Anspruch, **dadurch gekennzeichnet, dass** der günstige Bereich durch einen Spannungsbereich definiert ist, der im Totalvariationsbereich der Spannung an den Klemmen der Batterie in einer Vollauflade- oder Vollentladephase strikt enthalten ist, oder dadurch, dass der günstige Bereich als ein Bereich des Ladezustands SOC der Batterie ausgedrückt wird, der in dem Totalvariationsbereich des Ladezustands der Batterie in einer Vollauflade- oder Vollentladephase strikt enthalten ist.

3. Verfahren zur Schätzung des Gesundheitszustands einer Batterie nach einem der vorhergehenden Ansprüche, **dadurch gekennzeichnet, dass** der Schritt des Schätzens (E16) des Gesundheitszustands der Batterie anhand des Ergebnisses des Messschritts (E14) der zweiten Mess- und Schätzphase (P2) eine zeitliche Integration mindestens einer Größe oder einer Kombination von Größen umfasst, die mit einer Ladungs- oder Energiemenge verknüpft ist(sind), die von der Batterie in einer Auflade- oder Entladephase der Batterie aufgenommen oder abgegeben wird, die insbesondere anhand der Spannung, des Stroms und/oder der Temperatur der Batterie über den günstigen Bereich berechnet wird.

4. Verfahren zur Schätzung des Gesundheitszustands einer Batterie nach dem vorhergehenden Anspruch, **dadurch gekennzeichnet, dass** der Messschritt (E14) der zweiten Mess- und Schätzphase (P2) eine der folgenden Messungen umfasst:
- das Aufladen oder Entladen erfolgt bei konstantem Strom I, der Messschritt (E14) umfasst das Messen der Dauer (t2-t1) des Aufladens oder Entladens über den günstigen Bereich, um daraus eine übertragene oder von der Batterie abgegebene Ladungsmenge Q durch die Formel Q = I ^{∗} (t2-t1) herzuleiten; oder
- das Aufladen oder Entladen erfolgt bei variablem Strom I(t), der Messschritt (E14) umfasst das Messen des Stroms I(t) und die zeitliche Integration des Stroms zwischen dem Beginnzeitpunkt t1 und dem Endzeitpunkt t2 des günstigen Bereichs, um daraus eine übertragene oder von der Batterie abgegebene Ladungsmenge Q durch die Formel Q = ∫ I dt herzuleiten; oder
- der Messschritt (E14) umfasst das Messen des Stroms I(t) und der Spannung U(t) und die zeitliche Integration des Produkts aus dem Strom und der Spannung zwischen dem Beginnzeitpunkt t1 und dem Endzeitpunkt t2 des günstigen Bereichs, um daraus eine übertragene oder von der Batterie abgegebene Energiemenge E durch die Formel E = ∫ U. I dt herzuleiten.

5. Verfahren zur Schätzung des Gesundheitszustands einer Batterie nach einem der vorhergehenden Ansprüche, **dadurch gekennzeichnet, dass** der Messschritt (E14) der zweiten Mess- und Schätzphase (P2) mindestens eine Messung einer Größe umfasst, die mit einer Ladungs- oder Energiemenge verknüpft ist, die von der Batterie in einer Auflade- oder Entladephase der Batterie über einen günstigen Bereich aufgenommen oder abgegeben wird, dessen Grenzen sind:
- fix, unabhängig von der Alterung der Batterie, wobei die Variation des Innenwiderstands der Batterie als vernachlässigbar betrachtet wird; oder
- fix, unabhängig von der Alterung der Batterie, wobei die zur Schätzung des Gesundheitszustands im Schätzschritt (16) herangezogenen Referenzdaten, insbesondere in Diagrammform, es ermöglichen, eine Korrektur der Variation des Alterungszustands der Batterie mit deren Alterung zu berücksichtigen;
- mit der Zeit variabel, wobei ihre Variation anhand einer Schätzung oder einer Berechnung des Innenwiderstands der Batterie berechnet wird, entweder anhand einer Detektion einer Variation eines Maximums der Ableitung der Ladung durch die Spannung in Abhängigkeit von der Spannung oder umgekehrt in Bezug auf dieses Maximum, das im Neuzustand der Batterie erhalten wird, oder durch eine Berechnung anhand von Stromimpulsen oder durch Impedanzmessung.

6. Verfahren zur Schätzung des Gesundheitszustands einer Batterie nach einem der vorhergehenden Ansprüche, **dadurch gekennzeichnet, dass** die Kalibrierungsphase (P1) anhand von mindestens einer Batterie der Batteriefamilie im Neuzustand und anhand derselben Batterie in einem Alterungszustand ausgeführt wird.

7. Verfahren zur Schätzung des Gesundheitszustands einer Batterie nach einem der vorhergehenden Ansprüche, **dadurch gekennzeichnet, dass** die Kalibrierungsphase (P1) eine Aufladung oder Entladung bei konstantem Strom und/oder konstanter Temperatur durchführt und dass die Phase zum Messen und Schätzen (P2) des Gesundheitszustands der Batterie eine Teilaufladung oder Teilentladung über den günstigen Bereich bei konstantem Strom und/oder konstanter Temperatur durchführt, wobei für den Strom und die Temperatur im Wesentlichen die gleichen Werte wie in der Kalibrierungsphase gewählt werden.

8. Verfahren zur Schätzung des Gesundheitszustands nach einem der vorhergehenden Ansprüche, **dadurch gekennzeichnet, dass** die zweite Mess- und Schätzphase (P2) alle oder einen Teil der folgenden vorherigen Schritte im Hinblick auf die Bestimmung seines Auslösens umfasst:
- (E11a) Auslösebefehl nach einer Anforderung eines Nutzers über eine Mensch-Maschine-Schnittstelle einer Vorrichtung, in der die Batterie verwendet wird, oder einer Batterieladevorrichtung; und/oder
- (E11b) automatisches Auslösen gemäß einer vorgegebenen Häufigkeit; und/oder
- (E11c) automatisches Auslösen, wenn die elektrischen Bedingungen der Batterie dem günstigen Bereich entsprechen;
- (E11d) automatisches Auslösen während einer Aufladephase einer Batterie;
UND/ODER dadurch, dass es die folgenden vorherigen Schritte umfasst:
- einen Schritt der automatischen Detektion (E12) der elektrischen Situation der Batterie, um zu detektieren, dass sie sich in der richtigen Konfiguration gegenüber dem günstigen Bereich befindet; oder
- einen Schritt des Änderns (E13) der Konfiguration der Batterie, um sie an den Anfang des günstigen Bereichs zu setzen.

9. Verfahren zur Schätzung des Gesundheitszustands einer Batterie nach dem vorhergehenden Anspruch, **dadurch gekennzeichnet, dass** der Messschritt (E14) der zweiten Mess- und Schätzphase (P2) das Vergleichen, insbesondere das Verhältnis, der Größe, die mit einer Ladungs- oder Energiemenge verknüpft ist, die von einer Batterie aufgenommen oder abgegeben wird, berechnet über den günstigen Zeitraum, und der gleichen Größe, die auf die gleiche Weise über den günstigen Bereich im Neuzustand der Batterie berechnet wird, umfasst.

10. Verfahren zur Schätzung des Gesundheitszustands einer Batterie nach einem der vorhergehenden Ansprüche, **dadurch gekennzeichnet, dass** der günstige Bereich in Abhängigkeit von der Alterung der Batterie verschoben wird, um den durch die Änderung des Innenwiderstands der Batterie bedingten Fehler zu korrigieren.

11. Datenträger, der von einer Verwaltungseinheit gelesen werden kann, **dadurch gekennzeichnet, dass** er ein gespeichertes Computerprogramm umfasst, das Computerprogrammcodemittel zum Ausführen des Verfahrens zur Schätzung des Gesundheitszustands einer Batterie nach einem der vorhergehenden Ansprüche umfasst.

12. Vorrichtung, die mindestens eine Batterie und eine Verwaltungseinheit umfasst, **dadurch gekennzeichnet, dass** die Verwaltungseinheit ein Verfahren zur Schätzung des Gesundheitszustands mindestens einer Batterie nach einem der Ansprüche 1 bis 10 ausführt.

13. Vorrichtung nach dem vorhergehenden Anspruch, **dadurch gekennzeichnet, dass** sie ein Kraftfahrzeug oder ein tragbarer Gegenstand wie ein Computer, ein Telefon, ein Tablet oder ein elektronischer Terminplaner ist.

## Claims

1. Method for estimating the state of health (SOH) of a battery, **characterized in that** it comprises the following phases:
- a first phase (P1) of calibration of one or more batteries from the same family of batteries, comprising:
▪ a step (E1) of measuring the change in charge as a function of voltage, or vice versa, during charging or discharging of a battery, for one or more state-of-health values of the one or more batteries, including at least for the state in which said battery is new, and
▪ a step (E2) of detecting a maximum value of the derivative of charge by voltage as a function of voltage, or vice versa, and determining a favourable voltage range or charge range, respectively, the favourable range corresponding to partial charging or discharging of a battery that covers this maximum value, and
▪ a step (E3) of determining a law connecting a quantity related to an amount of charge or energy supplied or released by a battery during a phase of charging or discharging of the battery over the favourable range to the state of health of the battery, in particular by linear interpolation on the basis of the measurements taken over the favourable range, and/or constructing a chart associating a state-of-health value of the battery with a quantity related to an amount of charge or energy supplied or released by the battery, so as to determine reference data comprising information regarding a quantity related to an amount of charge or energy supplied or released by a battery during a phase of charging or discharging of the battery over the favourable range and the state of health of the battery;
- a second phase (P2) of measurement and of estimation of the state of health of the battery, comprising the following two steps:
▪ a step (E14) of measuring at least one quantity related to an amount of charge or energy supplied or released by the battery during a phase of partial charging or discharging of the battery over the favourable range;
▪ a step (E16) of estimating the state of health of the battery on the basis of the result of the measurement step (E14) and the reference data established during the first calibration phase.

2. Method for estimating the state of health of a battery according to the preceding claim, **characterized in that** the favourable range is defined by a voltage range strictly contained within the total range of variation in the voltage across the terminals of the battery during a phase of full charging or discharging, or **in that** the favourable range can be expressed as a range of state of charge SOC of the battery strictly contained within the total range of variation in the state of charge of the battery during a phase of full charging or discharging.

3. Method for estimating the state of health of a battery according to either of the preceding claims, **characterized in that** the step (E16) of estimating the state of health of the battery on the basis of the result of the measurement step (E14) in the second measurement and estimation phase (P2) comprises the integration over time of at least one quantity, or of a combination of quantities, related to an amount of charge or energy supplied or released by the battery during a phase of charging or discharging of the battery, calculated in particular on the basis of the voltage, the current and/or the temperature of the battery over the favourable range.

4. Method for estimating the state of health of a battery according to the preceding claim, **characterized in that** the measurement step (E14) in the second measurement and estimation phase (P2) comprises one of the following measurements:
- the charging or discharging is performed at a constant current I, and the measurement step (E14) comprises measuring the time (t2-t1) taken by charging or discharging over the favourable range so as to derive therefrom an amount of charge Q transferred or released by the battery using the formula Q = I^{∗}(t2-t1); or
- the charging or discharging is performed at a variable current I(t), and the measurement step (E14) comprises measuring the current I(t) and integrating the current over the time between the start time t1 and end time t2 of the favourable range so as to derive therefrom an amount of charge Q transferred or released by the battery using the formula Q = *∫* I dt; or
- the measurement step (E14) comprises measuring the current I(t) and the voltage U(t) and integrating the product of the current and the voltage over the time between the start time t1 and end time t2 of the favourable range so as to derive therefrom an amount of energy E transferred or released by the battery using the formula E = ∫ U.I dt.

5. Method for estimating the state of health of a battery according to one of the preceding claims, **characterized in that** the measurement step (E14) in the second measurement and estimation phase (P2) comprises at least one measurement of a quantity related to an amount of charge or energy supplied or released by the battery during a phase of charging or discharging of the battery over a favourable range, the limits of which are:
- fixed regardless of the ageing of the battery, the variation in the internal resistance of the battery being considered to be negligible; or
- fixed regardless of the ageing of the battery, the reference data consulted in order to estimate the state of health in the estimation step (16), in particular in the form of a chart, making it possible to take into account a correction of the variation in the internal resistance of the battery as it ages;
- variable over time, the variation therein being calculated on the basis of an estimation or a calculation of the internal resistance of the battery, either on the basis of the detection of a variation in a maximum value of the derivative of charge by voltage as a function of voltage or, in contrast, with respect to this maximum value obtained in the state in which the battery is new, or by performing a calculation on the basis of current pulsing or by measuring the impedance.

6. Method for estimating the state of health of a battery according to one of the preceding claims, **characterized in that** the calibration phase (P1) is performed on the basis of at least one battery from the family of batteries in the state in which said battery is new, and on the basis of the same battery in an aged state.

7. Method for estimating the state of health of a battery according to one of the preceding claims, **characterized in that** the calibration phase (P1) employs charging or discharging at a constant current and/or a constant temperature and **in that** the phase (P2) of measurement and of estimation of the state of health of the battery employs partial charging or discharging over the favourable range at a constant current and/or a constant temperature, the current and the temperature being chosen so as to have substantially the same values as in the calibration phase.

8. Method for estimating the state of health of a battery according to one of the preceding claims, **characterized in that** the second measurement and estimation phase (P2) comprises some or all of the following preliminary steps, for the purpose of determining the triggering of said phase:
- (E11a) trigger command following a request by a user via a human-machine interface of a device in which the battery is used or of a device for charging the battery; and/or
- (E11b) automatic triggering at a predefined frequency; and/or
- (E11c) automatic triggering when the electrical conditions of the battery correspond to the favourable range;
- (E11d) automatic triggering during a phase of charging of a battery;
AND/OR **in that** it comprises the following preliminary steps:
- a step (E12) of automatically detecting the electrical situation of the battery in order to detect that it is in the correct configuration with respect to the favourable range; or
- a step (E13) of changing the configuration of the battery in order to place it at the beginning of the favourable range.

9. Method for estimating the state of health of a battery according to the preceding claim, **characterized in that** the measurement step (E14) in the second measurement and estimation phase (P2) comprises comparing the quantity related to an amount of charge or energy supplied or released by a battery calculated over the favourable range with the same quantity calculated in the same manner over the favourable range in the state in which the battery is new, in particular establishing the ratio of said quantities.

10. Method for estimating the state of health of a battery according to one of the preceding claims, **characterized in that** the favourable range is shifted on the basis of the ageing of the battery so as to correct the error resulting from the change in the internal resistance of the battery.

11. Computer medium that can be read by a management unit, **characterized in that** said computer medium comprises a recorded computer program comprising computer program code means for implementing the method for estimating the state of health of a battery according to one of the preceding claims.

12. Device comprising at least one battery and a management unit, **characterized in that** the management unit implements a method for estimating the state of health of at least one battery according to one of Claims 1 to 10.

13. Device according to the preceding claim, **characterized in that** it is a motor vehicle or a mobile device such as a computer, a telephone, a tablet or an electronic organizer.
